# EUROPEAN PATENT SPECIFICATION

(11) **EP 4 531 092 B1**
(45) Date of publication and mention of the grant of the patent: **17.06.2026**
(21) Application number: 24202397.6
(22) Date of filing: 25.09.2024
(51) Int. Cl.: H10W 70/692, H10W 99/00, H10W 70/60, H10W 70/68, H10W 74/10, H10W 70/05, H10W 70/685

(54) **PACKAGING SUBSTRATE AND MANUFACTURING METHOD OF THE SAME**
VERPACKUNGSSUBSTRAT UND HERSTELLUNGSVERFAHREN DAFÜR
SUBSTRAT D'EMBALLAGE ET SON PROCÉDÉ DE FABRICATION

(30) Priority: 27.09.2023 US 202363540926 P
(43) Date of publication of application: 02.04.2025
(73) Proprietor: Absolics Inc., Covington, GA 30014 (US)
(72) Inventor: KIM, Tae Kyoung, Covington, Georgia, ,, 30014 (US); KIM, Sungjin, Covington, Georgia,, 30014 (US); LEE, Chun Jae, 18469 Hwaseong-si, Gyeonggi-do (KR)
(74) Representative: BCKIP Part mbB

(56) References cited:
- DE-A1- 102021 123 777
- JP-A- 2017 073 424
- US-A1- 2019 162 778
- US-A1- 2019 219 882
- US-A1- 2021 351 094

## Description

This application claims the priority of U.S. Provisional Patent Application No. 63/540,926, filed September 27, 2023.

### BACKGROUND

### 1. Field

These embodiments relate to a semiconductor packaging substrate and a method of manufacturing a semiconductor packaging substrate, and a packaging substrate comprising a glass substrate and a method of manufacturing the same.

### 2. Description of Related Art

In manufacturing electronic components, implementing a circuit on a semiconductor wafer is called as a front-end (FE) process, assembling the wafer in a state of being usable in an actual product is called as a back-end (BE) process, and a packaging process is included in this back-end process.

Four core technologies of semiconductor industry, which recently enabled rapid development of electronic products, include semiconductor technology, semiconductor packaging technology, manufacturing process technology, and software technology. Semiconductor technology has developed in various forms, such as nanoscale (submicron) line widths, 10 million cells or more, high-speed operation, large heat dissipation, and the like, but a relatively sufficient packaging technology is not supported. Accordingly, the electrical performance of a semiconductor can sometimes be determined by the packaging technology and the electrical connection according to the packaging technology rather than performance of the semiconductor technology itself.

Although a ceramic or resin has been applied as a material of a packaging substrate, recently, research on applying silicon or glass for a high-end packaging substrate has been performed, and specifically, a packaging substrate having a cavity structure has been developed by applying a glass substrate.

Meanwhile, a re-distribution layer (RDL) in the packaging process refers to a generic technology of changing a position of a previously formed electrical terminal (for example: an Al pad) to an arbitrary position using a wafer level package (WLP) process technology. This RDL is used as a method of solving a design limitation in a semiconductor manufacturing process through a package, that is, is used in semiconductor chip stacking.

Related prior art includes United State Patent Publication US 2022/0336481 A1 and Korean Patent Publication 10-2020-0133340 and the like.

Document US 2021 / 0 351 094 A1 discloses a package substrate that prevents breakage of a core substrate. A package substrate includes a core substrate made of a brittle material, at least one insulating layer formed on one surface or both surfaces of the core substrate, and one or more wiring layers formed on the insulating layer and/or in the insulating layer, the core substrate being exposed from an outer peripheral portion of the insulating layer, and the insulating layer being chamfered.

Document JP 2017 073 424 A discloses a wiring board comprising a glass substrate and lamination parts. The glass has a shape having a plurality of corners when viewed from a thickness direction. The lamination parts have a structure where resin insulation layers are laminated. An end face of the glass substrate and end faces of the resin insulation layers are exposed on a lateral face of the wiring board. At each corner part, a beveled part is formed. At the beveled part, the end faces of the resin insulation layers are retracted behind the end face of the glass substrate and closer to a central part of the wiring substrate.

Document US 2019 / 0 162 778 A1 discloses a multilayer wiring board for inspection of electronic components. A multilayer wiring board includes: a ceramic wiring substrate having a substrate main surface and a substrate rear surface; substrate-side conductive layers formed on the substrate main surface; and a resin wiring portion stacked on the substrate main surface. An outer peripheral edge of a rear surface of the resin wiring portion is in contact with the surfaces of the substrate-side conductive layers, and end surfaces of the resin wiring portion and the end surfaces of the substrate-side conductive layers are positioned closer to the center of the board than end surfaces of the ceramic wiring substrate.

### SUMMARY

The purpose of the present invention is to provide a glass substrate and a packaging substrate that mounts multiple elements on a glass substrate, wherein the packaging substrate can easily detect defects that may occur thereon and a manufacturing method thereof.

In addition, the purpose of the present invention is to provide a packaging substrate that can simultaneously detect defects on the surface and cross section of the glass substrate and a manufacturing method thereof.

In addition, the purpose of the present invention is to reduce time and cost when inspecting the glass substrate and confirming its quality.

In order to achieve the above object, the present invention provides a manufacturing method of a packaging substrate in accordance with claim 1.

According to an example, which is helpful to understand the present invention, a packaging substrate may include a glass substrate including a first surface and a second surface facing each other, and an upper layer stacked on the first surface, or a lower layer stacked on the second surface, and the glass substrate may have an edge region which is an edge protruding from the upper layer or the lower layer.

The upper layer may include a first insulating layer laminated on the first surface.

An edge of the first insulating layer may be disposed inward from an edge of the glass substrate, and the edge region may include a region from an edge of the glass substrate to an edge of the first insulating layer.

In addition, the lower layer may also include a second insulating layer laminated on the second surface. An edge of the second insulating layer may be disposed inward from an edge of the glass substrate, and the edge region may include a region from an edge of the glass substrate to an edge of the second insulating layer.

The width from the edge of the first insulating layer to the edge of the glass substrate may be 5 µm to 200 µm.

The width from the edge of the second insulating layer to the edge of the glass substrate may be 5 µm to 200 µm.

The edge region disposed at the edge of the glass substrate may have a curved surface.

In another embodiment, the edge region may be chamfered.

The edge of the glass substrate at the edge region disposed may be chamfered.

Each of the upper layer or the lower layer may have a tapered shape thinning toward the edge of the glass substrate.

Each of the upper layer or the lower layer may have a tapered shape thinning toward a cut surface of the glass substrate.

A semiconductor element may be mounted on the upper layer.

To achieve the above objective, a manufacturing method of a packaging substrate
according to one embodiment includes a forming operation of an upper layer on a first surface of a glass substrate which includes a first surface and a second surface facing each other; a removing operation of the upper layer by a predetermined width along a predetermined cutting line; a forming operation of a filamentation along a cutting line on the glass substrate from which the upper layer has been removed; and a cutting operation of the glass substrate using the filamentation.

The manufacturing method of the packaging substrate, before the forming operation of the filamentation, may further include a forming operation of a lower layer on the second surface; and a removing operation of the lower layer by a predetermined width along the cutting line.

The predetermined width from which the upper layer or the lower layer is removed may be 5 µm or more. In addition, the width may be 200 µm or less.

The upper layer and/or the lower layer may have a tapered shape thinning toward a cut surface of the glass substrate.

In the cutting operation of the glass substrate, the glass substrate may be separated by applying tensile stress or rotational force to the filament, and the cut surface of the glass substrate is prepared.

After the cutting operation of the glass substrate, the manufacturing method of the packaging substrate may further include a grinding operation of the cut surface of the glass substrate.

The edge area includes the edge of the glass substrate; and an area of the glass substrate above protruding from the upper layer above or the lower layer above.

The manufacturing method of a packaging substrate may further include a detecting operation of defects in an edge region of the glass substrate from which the upper layer or the lower layer is removed and a cut surface of the glass substrate.

### BRIEF DESCRIPTION OF THE DRAWINGS

FIG. 1 is a conceptual diagram illustrating a cross-sectional structure of a packaging substrate according to an embodiment.
FIG. 2 is a conceptual diagram illustrating a cross-sectional structure of a packaging substrate according to another embodiment.
(a) and (b) of FIG. 3 are conceptual views each illustrating a part of a packaging substrate in a cross section according to one or more embodiment.
FIG. 4 is a flowchart illustrating a process of preparing a core distribution layer in a cross-section during a manufacturing method of a packaging substrate according to an embodiment.
FIG. 5 is a flowchart illustrating a forming operation of an insulating layer in a cross-section during a manufacturing method of a packaging substrate according to an embodiment.
(a) to (c) of FIG. 6 are views for explaining a cross section of a packaging substrate according to an embodiment.
FIG. 7 is a view illustrating a packaging substrate viewed from above according to an embodiment; Gr means glass cracks, and Gh means glass chipping.
FIG. 8 is a flowchart illustrating a manufacturing method of a packaging substrate in a cross section according to an embodiment; (a) is Laser Ablation, (b) is Laser Filamentation, and (c) is Separation.
FIG. 9 is a flowchart illustrating a cross-section of a manufacturing method of a packaging substrate according to another embodiment; (a) is Laser Ablation, (b) is Laser Filamentation, and (c) is Separation.
(a) and (b) of FIG. 10 are photographs at a process of manufacturing a packaging substrate according to an embodiment; the left side of (a) and (b) are the sectional view, and the right side of (a) is the top view.
FIG. 11 is a photographing a cross section of a ground glass substrate according to an embodiment; the solid line represents the cutting line (CL) and the dotted line represents the polished glass edge.
FIG. 12 is a photograph of a glass substrate viewed from above and a portion thereof according to another embodiment.

### DETAILED DESCRIPTION

Hereinafter, one or more embodiments will be described in detail by referring to the accompanying drawings so that the skilled person in the technical field to which the invention belongs may easily implement it. However, the embodiments may be implemented in several different forms and are not limited to the embodiments described herein. The same reference numerals are attached to similar parts throughout the specification.

In the present specification, the term "combination thereof" included in the expression of the Markush form means one or more mixtures or combinations selected from the group consisting of the components described in the Markush type expression, and it comprises one or more selected from the group consisting of the above components.

In the present specification, terms such as "first", "second", or "A", "B" are used to distinguish the same terms from each other unless otherwise specified. In addition, a singular expression is interpreted as meaning including a singular or plural interpreted in the context unless otherwise described.

In the present specification, the term "~" based may mean that a compound corresponding to "~" or a derivative of "~" is included in the compound.

In the present specification, the meaning that B is located on A means that B is located directly on A or B is located on A while another layer is located in between and is not interpreted as being limited to B being located on A's surface.

In the present specification, connecting to B on A means that A and B are directly connected or between A and B through other components, and unless otherwise stated, A and B are not limited to being directly connected.

In the present specification, a singular expression is interpreted as meaning including a singular or plural interpreted in the context unless otherwise described.

In the process of developing semiconductor devices that can perform more integrated and thinner, the inventors recognized that not only the device itself but also the packaging was an important factor in performance improvement and continued their research. While studying this, the inventors confirmed that the packaging substrate can be made thinner and more helpful in improving the electrical properties of the semiconductor element by applying a single layer of glass core and a cavity structure, unlike the application of two or more cores on the motherboard such as existing interposer and organic substrate.

On the other hand, there is a possibility that the glass substrate may crack or chipping split into pieces due to internal stress and/or external impact during the process. In addition, in order to detect this, a cross-sectional analysis that requires high cost is required. For example, in order to detect cracks or damage, an inspection using a microscope or the like may be required on all cut surfaces of the glass substrate, and such an inspection may take considerable time and cost.

Therefore, as a result of repeated research, it was confirmed that the inspection of the core substrate could be easily performed by protruding the glass substrate in the direction of the cut surface rather than the layer stacked on the upper or lower part. In other words, by exposing a part of the glass substrate, it was confirmed that it was possible to quickly detect defects in the surface and cross section of the glass substrate without instruments such as a microscope, and the invention was completed.

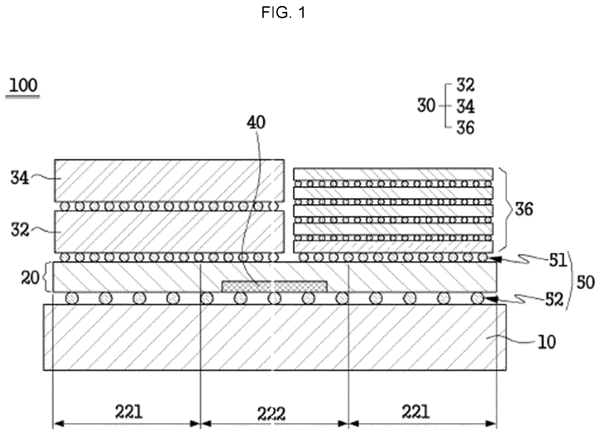

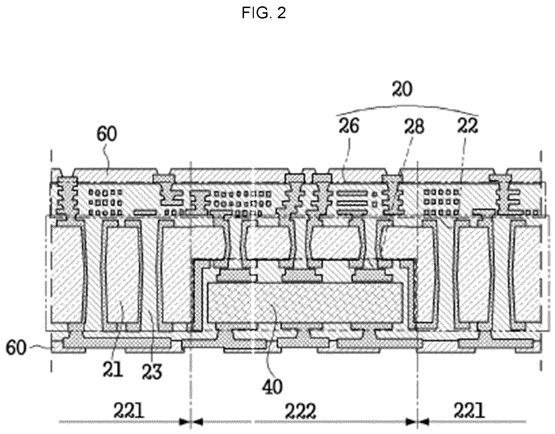

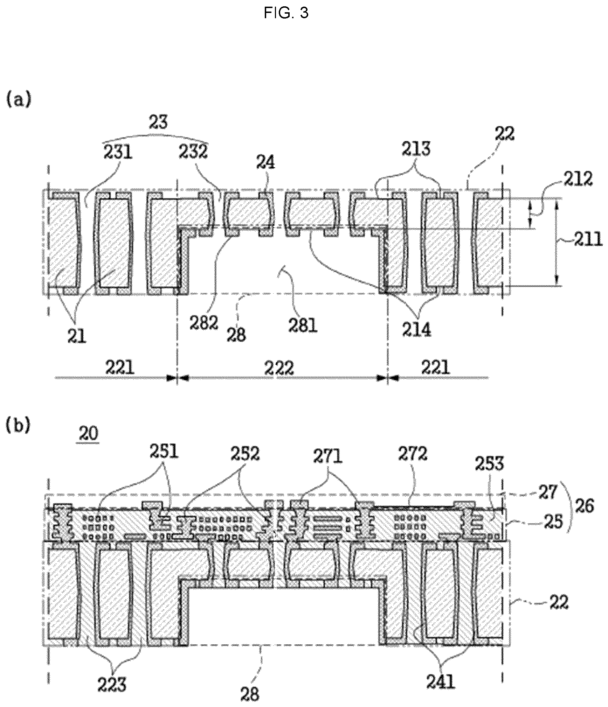

FIG. 1 is a conceptual diagram illustrating a cross-sectional structure of a packaging substrate according to an embodiment. FIG. 2 is a conceptual diagram illustrating a cross-sectional structure of a packaging substrate according to another embodiment. And (a) and (b) of FIG. 3 are conceptual views each illustrating a part of a packaging substrate in a cross section according to one or more embodiment.

In order to achieve the above object, a semiconductor device 100 according to the embodiment comprises a semiconductor element portion 30 in which one or more semiconductor elements 32, 34, and 36 are located, a packaging substrate 20 electrically connected to the semiconductor elements, and a motherboard 10 that is electrically connected to the packaging substrate 20, transmits an external electrical signal to the semiconductor elements 32, 34, and 36.

The packaging substrate 20 according to the embodiment comprises a core layer 22, an upper layer 26 located on one surface of the core layer 22, and a cavity portion 28 in which a cavity element 40 may be located.

The semiconductor element portion 30 refers to elements mounted in the semiconductor device, and is mounted on the packaging substrate 20 by a connection electrode or the like. Specifically, as the semiconductor element portion 30, for example, arithmetic elements (a first element 32 and a second element 34) such as a central processing unit (CPU), a graphics processing unit (GPU), and the like, a storage element (a third element 36) such as a memory chip, and the like may be applied, but any semiconductor element mounted on a semiconductor device may be applied without limitation.

A motherboard such as a printed circuit board, a printed wiring board, or the like may be applied as the motherboard 10.

The packaging substrate 20 may selectively further comprise a lower layer (not shown) located under the core layer.

The core layer 22 may comprise a glass substrate 21 comprising a first region 221 having a first thickness 211 and a second region 222 adjacent to the first region 221 and having a second thickness 212 thinner than the first thickness; a plurality of core vias 23 passing through the glass substrate 21 in a thickness direction, and a core distribution layer 24 that is located on a surface of the glass substrate 21 or the core via 23 and electrically connects a first surface 213 of the glass substrate 21 and a second surface 214 facing the first surface 213 through the core vias 23. That is, the core layer 22 may refer to a glass structure, which is the glass substrate 21 comprising the first surface 213 and the second surface 214 facing each other, the core vias 23, and the cavity portion 28, or all of these.

The second region 222 of the core layer 22 may serve as a cavity structure.

In the same region, the glass substrate 21 has the first surface 213 and the second surface 214 facing each other, and these two surfaces are generally parallel to each other and have uniform thicknesses throughout the glass substrate 21.

An inner space 281 formed by a thickness difference between the first region 221 and the second region 222 serves to accommodate parts or all of the cavity element 40.

The glass substrate 21 may comprise the core vias 23 passing through the first surfaces 213 and the second surfaces 214. The core vias 23 may be formed in both the first region 221 and the second region 222, and may be formed with an intended pitch and pattern.

Conventionally, a form in which a silicon substrate and an organic substrate are stacked was applied as a packaging substrate for a semiconductor device. In the case of silicon substrates, there is a concern that parasitic elements might be occurred when applied to a high-speed circuit due to its nature of semiconductor, and a disadvantage in that power loss is relatively large. Further, in the case of organic substrates, a large area is required to form a more complicated distribution pattern, but this does not conform to the trend of manufacturing miniaturized electronic devices. In order to form a complicated distribution pattern within a predetermined size, pattern miniaturization is substantially required, but there is a practical limit to pattern miniaturization due to the nature of materials such as polymers and the like applied to organic substrates.

In the embodiment, as a method of solving such problems, the glass substrate 21 is applied as a support of the core layer 22. Further, a packaging substrate 20 having a relatively shortened electrical flow, a relatively compact size, a faster response, and less loss characteristics is provided by applying the core vias 23 formed to pass through the glass substrates 21 along with the glass substrate 21.

As the glass substrate 21, a glass substrate applied to a semiconductor may be applied, and for example, a borosilicate glass substrate, an alkali-free glass substrate, or the like may be applied, but the present disclosure is not limited thereto.

The core vias 23 passes through the glass substrate 21. The core vias 23 may be formed by a method of removing predetermined regions of the glass substrate 21, and may be formed by physically and/or chemically etching plate-shaped glass.

Specifically, the formation of the core vias 23 may be performed by chemically etching or laser etching, or the like after forming defects (flaws) on the surface of the glass substrate using a method such as a laser, but the present disclosure is not limited thereto.

The number of corevias 23 located in the glass substrate 21 based on a unit area (1 cm x 1 cm) may be 100 to 3,000, 100 to 2,500, or 225 to 1,024. When this pitch condition is satisfied, the formation of an electrically conductive layer and the like and a performance of a packaging substrate may be improved.

The core distribution layer 24 comprises a core distribution pattern 241 which is an electrically conductive layer electrically connecting the first surface and the second surface of the glass substrate through through-vias, and a core insulating layer 223 surrounding the core distribution pattern 241. The core layer 22 may be formed with the electrically conductive layer therein through the core vias to serve as an electrical path crossing the glass substrate 21, and may connect upper and lower portions of the glass substrate with a relatively short distance to have characteristics of faster electrical signal transmission and low loss. For example, a copper-plated layer may be applied as the electrically conductive layer, but the present disclosure is not limited thereto.

The cavity portion 28 is substantially not limited to a shape such as a circular shape, a triangular shape, a quadrangular shape, a hexagonal shape, an octagonal shape, a cross shape, and the like.

The cavity element 40 may generally be a cylindrical shape, rectangular parallelepiped shape, or a polygonal pillar shape.

The cavity portion 28 may comprise a cavity distribution pattern, which is an electrically conductive layer electrically connecting the cavity element 40 and the core distribution layer 24, and an insulating layer which surrounds the cavity distribution pattern.

Meanwhile, a cavity portion according to another embodiment may be implemented in the form of passing through the first surface 213 and the second surface 214 of the glass substrate 21. In this case, the cavity portion may be formed according to the same process as a process of forming the core via 23, and the area and shape passing through the glass substrate 21 may be different from those of the core via 23.

In this embodiment, after the cavity element 40 is arranged in the cavity portion, an insulating layer may be formed. That is, the insulating layer may also be prepared in the cavity portion through a process of preparing the above-described core insulating layer 223.

The core distribution pattern 241 may be formed to be electrically connected to the cavity element 40.

The cavity element 40 may comprise an active element such as a transistor or a power transmission element such as a multilayer ceramic capacitor (MLCC), that is, a passive element.

When an element such as a transistor serving to convert an electrical signal between a motherboard and a semiconductor element portion to an appropriate level is applied as the cavity element 40, since a transistor or the like is applied to the path of the packaging substrate 20, a more efficient and faster semiconductor device 100 may be provided.

Further, a power transmission element such as a multilayer ceramic capacitor (MLCC) plays an important role in the performance of a semiconductor element. Generally, at least 200 or more power transmission elements, which are passive elements, are applied to a semiconductor element, and performance thereof is also affected by the characteristics of an electrically conductive layer around the element in power transmission. In one embodiment, a core via having a non-circular shape rather than a circular shape may be applied to a place where a low-resistance electrically conductive layer is required, such as a power transmission element.

Meanwhile, a passive element such as a capacitor or the like may be individually inserted into and applied to the cavity element 40, and an element group comprising a plurality of passive elements in the form of being embedded between insulator layers (cavity element insulating layers) may be formed such that electrodes are exposed, and then inserted into the cavity element. In the latter case, the workability of manufacturing the packaging substrate may become smoother, and there is a relative advantage in that the insulating layer is sufficiently and reliably located in a space between complicated elements.

The glass substrate 21 serves as an intermediate and intermediary, which connect the semiconductor element portion 30 and the motherboard 10 at an upper portion and a lower portion, respectively, and the core vias 23 serve as paths through which the electrical signals thereof are transmitted, and thus smoothly transmit the signals. In order to distinguish it from a core via of the second region 222, which will be described later, the core via disposed in the first region 221 is called the first region core via 231.

The upper layer 26 is located on the first surface 213.

The upper layer 26 comprises an upper distribution layer 25 and an upper surface connection layer 27 located on the upper distribution layer 25, and the uppermost surface of the upper layer 26 may be protected by a cover layer 60 formed with an opening that may come into direct contact with the connection electrode of the semiconductor element portion.

The upper distribution layer 25 comprises an upper insulating layer 253 located on the first surface, and an upper distribution pattern 251 embedded in the upper insulating layer 253 as an electrically conductive layer having a predetermined pattern and to which the core distribution layer 24 is at least partially connected. The upper distribution layers 25 arranged above and below each other may be connected to each other through blind vias 252.

Any one which is applied as an insulator layer in a semiconductor device or a packaging substrate may be applied as the upper insulating layer 253, for example, an epoxy-based resin or the like comprising a filler may be applied, but the present disclosure is not limited thereto.

The insulator layer may be formed by a method of forming and curing a coating layer, and may also be formed by a method of laminating an insulator film formed to be a film in an uncured or semi-cured state on the core layer 22 and curing the insulator film. In this case, when a pressure sensitive lamination method or the like is applied, since the insulator is incorporated into a space in the core via 23, an efficient process may be performed.

According to one embodiment, even when multi-layer insulator layers are stacked and applied, it may become difficult to substantially distinguish the insulator layers, and a plurality of insulator layers are collectively called an upper insulation layer. Further, the same insulating material may be applied to the core insulating layer 223 and the upper insulating layer 253, and in this case, a boundary thereof may not be substantially distinguished. Alternatively, according to another embodiment, the boundary of the insulator layers may be generated by setting the pressure and temperature for curing the multi-layer insulator layers differently.

The upper distribution pattern 251 refers to an electrically conductive layer located in the upper insulating layer 253 in a preset form, and may be formed, for example, using a buildup layer method. Specifically, the upper distribution pattern 251 formed with an electrically conductive layer in a vertical direction or horizontal direction in an intended pattern may be formed by repeating a method of forming an insulator layer, removing unnecessary portions of the insulator layer, forming an electrically conductive layer by a method of copper plating or the like, selectively removing unnecessary portions of the electrically conductive layer, forming another insulator layer on the electrically conductive layer, removing the unnecessary portions again, and then forming an electrically conductive layer by a plating method or the like.

The upper distribution pattern 251 is located between the core layer 22 and the semiconductor element portion 30, and thus is formed to comprise a micro pattern in at least a portion thereof so that transmission of the electrical signals with the semiconductor element portion 30 may be smoothly performed and an intended complicated pattern may be sufficiently accommodated. In this case, each of a width and an interval of the micro pattern may be smaller than 4 µm, 3.5 µm or less, 3 µm or less, or 2.5 µm or less, or may be 2.3 µm. each of a width and an interval of the micro pattern may be 1 µm or less (hereinafter, descriptions for the micro pattern are the same).

At least a portion of the upper surface connection layer 27 is electrically connected to the upper distribution pattern 251, and the upper surface connection layer 27 comprises an upper surface connection pattern 272 located on the upper insulating layer 253 and an upper surface connection electrode 271, which electrically connects the semiconductor element portion 30 and the upper surface connection pattern 272.

The upper surface connection pattern 272 may be located on one surface of the upper insulating layer 253, and may be embedded in the upper insulating layer while at least a portion of the upper surface connection pattern 272 may be exposed on the upper insulating layer. For example, when the upper surface connection pattern is located on one surface of the upper insulating layer, the upper insulating layer may be formed by a plating method or the like, and a case in which the upper surface connection pattern is embedded in the upper insulating layer while the portion of the upper surface connection pattern is exposed on the upper insulating layer may be a case in which a portion of the insulating layer or electrically conductive layer is removed by a method such as surface polishing, surface etching, or the like after a copper-plated layer or the like is formed.

At least a portion of the upper surface connection pattern 272 may comprise a micro pattern like the above-described upper distribution pattern 251. The upper surface connection pattern 272 comprising the micro pattern allows a relatively larger number of elements to be connected even in a small area to make an electrical signal connection between the elements or with the outside smooth, and more integrated packaging is possible.

The upper surface connection electrode 271 may be directly connected to the semiconductor element portion 30 through a terminal or the like, and may also be connected to the semiconductor element portion 30 through an element connection portion 51 such as a solder ball.

The cavity portion 28 is located on and/or under the second region 222 and comprises a cavity distribution layer 282 electrically connected to the core distribution pattern 241 and the inner space 281 in which the cavity element 40 is located. The cavity distribution layer 282 may be formed through the second resin core via 232.

Specifically, the thickness of the glass substrate 21 in the second region 222 is thinner than the thickness of the glass substrate 21 in the first region 221, and the cavity element 40 may be located at the inner space 281 formed due to the thickness difference. Further, the core vias 23 and the core distribution layer 24 formed in the glass substrate 21 serve as an electrical connection structure connecting the cavity element 40 and external elements.

Further, as described above, in the second region 222 other than the first region 221, that is, a cavity portion in the form of passing through the first surface 213 and the second surface 214 of the glass substrate 21 may be prepared, and the cavity element 40 may be arranged in the cavity portion.

The packaging substrate 20 is also connected to the motherboard 10. A terminal of the motherboard 10 may be directly connected to the core distribution pattern 241 located on at least a portion of the second surface 214 of the core layer 22, and the motherboard 10 may be electrically connected to the core distribution pattern 241 through a board connection portion 52 such as a solder ball. Further, the core distribution pattern 241, which comes into contact with the motherboard 10, may be connected to the motherboard 10 through a lower layer (not shown) located under the core layer 22. An element connection part 51 and a board connection part 52 are collectively referred to as a connection part 50.

According to an example, other additional substrates other than the glass substrate 21 may not be substantially applied to the packaging substrate 20 located between the semiconductor element portion 30 and the motherboard 10.

Conventionally, an interposer and an organic substrate were stacked together and applied between an element and a motherboard while connecting an element and the motherboard because a multi-stage form is applied for at least two reasons. One is that there is a scale problem in directly bonding a micro pattern of the element to the motherboard; and the other is that a problem of wiring damage due to a difference in thermal expansion coefficient may occur during a bonding process or a process of driving the semiconductor device. In the embodiment, this problem was solved by applying a glass substrate having a thermal expansion coefficient similar to that of a semiconductor element, and forming a micro pattern having a sufficiently fine scale for mounting the element on the first surface and an upper layer of the glass substrate.

Hereinafter, a manufacturing method according of a packaging substrate to the embodiment of the present disclosure will be described.

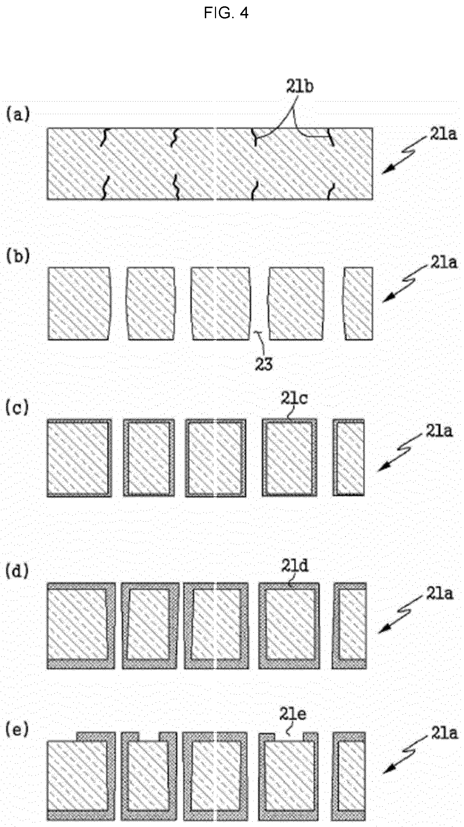

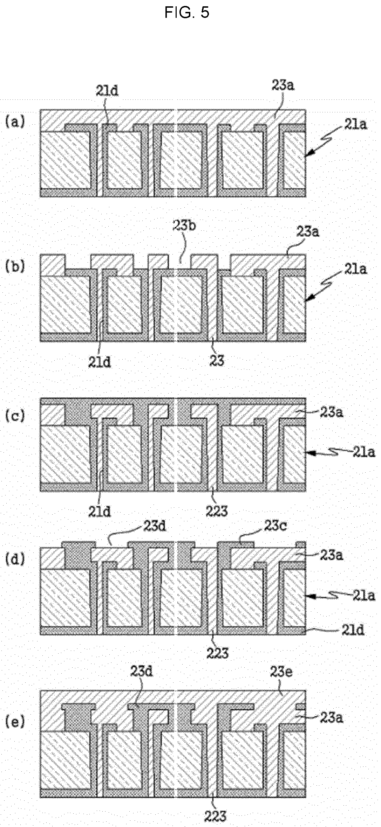

FIGS. 4 and 5 are flow charts for describing the packaging substrate manufacturing process according to the embodiment in cross-sections.

First, as shown in (a) of FIG. 4, a glass substrate 21a having flat first and second surfaces is prepared, and defects (flaws) 21b are formed at predetermined positions in a glass surface to form core vias. A glass applied to a substrate of an electronic device or the like may be applied as the glass substrate, for example, an alkali-free glass substrate may be applied as the glass substrate, but the present disclosure is not limited thereto. As commercially available products, products manufactured by manufacturers such as Corning, Schott, AGC, and the like may be applied. A method such as mechanical etching, laser irradiation, or the like may be applied to the formation of the defects (flaws).

As shown in (b) of FIG. 4, in the glass substrate 21a having the defects (flaws) 21b, an etching operation of forming the core vias 23 through a physical or chemical etching process is performed. During the etching process, the vias are formed in defective portions of the glass substrate, and the surface of the glass substrate 21a may also be etched. In order to prevent etching of the glass surface, a masking film or the like may be applied, but considering the inconvenience of applying and removing the masking film, the defective glass substrate itself may be etched, and in this case, a thickness of the glass substrate having the core vias may be somewhat thinner than the initial thickness of the glass substrate.

Thereafter, as shown in (c) and (d) of FIG. 4, a core layer manufacturing operation may be performed by forming an electrically conductive layer 21d on the glass substrate. A metal layer comprising copper metal may be representatively applied as the electrically conductive layer, but the present disclosure is not limited thereto.

Since the surface of the glass (comprising the surface of the glass substrate and a surface of the core via) and the surface of the copper metal have different properties, adhesion is low. In the embodiment, the adhesion between the glass surface and the metal may be improved by two methods such as a dry method and a wet method.

The dry method is a method of applying sputtering, that is, a method of forming a seed layer 21c on the glass surface and an inner diameter of the core via through metal sputtering. Dissimilar metals such as titanium, chromium, and nickel may be sputtered together with copper to form the seed layer, and in this case, a glass-metal adhesion may be improved by an anchor effect, in which metal particles interact with the surface morphology of the glass, or the like.

The wet method is a method of performing primer treatment, and is a method of forming a primer layer 21c by performing pre-treatment with a compound having a functional group such as an amine. According to the degree of intended adhesion, the primer treatment may be performed with a compound or particles having an amine functional group after performing pre-treatment with a silane coupling agent. As mentioned above, a support substrate of the embodiment needs to have to have high enough performance to form a micro pattern, and this should be maintained even after primer treatment. Accordingly, when such a primer comprises nanoparticles, nanoparticles having an average diameter of 150 nm or less may be applied, for example, nanoparticles having an amine group may be applied. The primer layer may be, for example, formed by applying a bonding strength improving agent, e.g., the CZ series manufactured by MEC or the like.

In the seed layer/primer layer 21c, the electrically conductive layer may selectively form the metal layer in a state in which unnecessary portions for the formation of the electrically conductive layer are removed or not removed. Further, in the seed layer/primer layer 21c, portions required or not required for the formation of the electrically conductive layer in an activated or deactivated state may be treated selectively with metal plating to perform subsequent processes. For example, light irradiation treatment such as a laser of a certain wavelength or the like, chemical treatment, or the like may be applied to the activation or deactivation treatment. A copper plating method or the like applied to semiconductor element manufacturing may be applied to the formation of the metal layer, but the present disclosure is not limited thereto.

As shown in (e) of FIG. 4, a portion of the core distribution layer may be removed when unnecessary, and after a portion of the seed layer is removed or deactivated, metal plating may be performed to form an electrically conductive layer in a predetermined pattern, and then form an etching layer 21e of the core distribution layer.

FIG. 5 describes a manufacturing operation of forming an insulating layer and an upper distribution pattern according to one embodiment.

As shown in (a) of FIG. 5, the core via may go through an insulating layer forming operation of filling an empty space with an insulating layer after forming the core distribution layer which is the electrically conductive layer. In this case, an insulating layer manufactured in the form of a film may be applied as the insulating layer to be applied, and for example, a pressure sensitive lamination method of the insulating layer in the form of a film, or the like may be applied. When the pressure sensitive lamination is performed like in this way, the insulating layer is sufficiently incorporated into the empty space in the core via to form a core insulating layer in which a void is not formed.

(b) to (e) of FIG. 5 describe a forming operation of an upper layer.

The forming operation of an upper layer is an operation of forming an upper distribution layer comprising an upper insulating layer and an upper distribution pattern on the core layer. The upper insulating layer may be formed by a method of coating a resin composition forming an insulating layer 23a or laminating insulating films, and for convenience, the method of laminating the insulating films is better. The laminating of the insulating films may be performed by a process of laminating and curing the insulating films, and in this case, when the pressure sensitive lamination method is applied, an insulating resin may be sufficiently incorporated even into a layer in which the electrically conductive layer is not formed in the core via or the like. An upper insulating layer which comes into direct contact with at least a portion of the glass substrate, and thus has sufficient adhesion is applied as the upper insulating layer. Specifically, the glass substrate and the upper insulating layer may have characteristics in which adhesion test values according to ASTM D3359 satisfy 4B or more.

The upper distribution pattern may be formed by repeating the process of forming an insulating layer 23a, and forming an electrically conductive layer 23c in a predetermined pattern and etching unnecessary portions to form an etching layer 23d of the electrically conductive layer, and electrically conductive layers formed adjacent to each other with the insulating layer therebetween may be formed by a method of performing a plating process after forming a blind via 23b in the insulating layer. A dry etching method such as laser etching, plasma etching, or the like, a wet etching method using a masking layer and an etchant, or the like may be applied to the formation of the blind via.

Hereinafter, although not shown in the drawings, an upper surface connection layer and a cover layer may be formed.

The upper surface connection pattern and the upper surface connection electrode may also be formed in a process similar to forming operation of the upper distribution layer. Specifically, the upper surface connection pattern and the upper surface connection electrode may be formed by a method of forming an etching layer of the insulating layer on an insulating layer 23e, forming an electrically conductive layer thereon, and then forming an etching layer of the electrically conductive layer, or the like, but a method of selectively forming only the electrically conductive layer without applying an etching method may also be applied. The cover layer may be formed so that an opening (not shown) may be formed at a position corresponding to the upper surface connection electrode and thus the upper surface connection electrode is exposed, and the cover layer may be directly connected to an element connection portion, a terminal of an element, or the like.

When the upper layer is formed, a forming operation of the lower layer may be performed by forming a lower connection layer and the cover layer. A lower distribution layer and/or the lower connection layer, and selectively, the cover layer (not shown) may be formed in a manner similar to the above-described operation of forming the upper surface connection layer and cover layer.

According to an embodiment, one or more semiconductor elements may be mounted on the packaging substrate 20. In the process of manufacturing the packaging substrate, multiple packaging substrates may be simultaneously manufactured on a large-area substrate, and the packaging substrate 20 may be cut into a predetermined unit, that is, a unit. For example, in the manufacturing process of a packaging substrate, there is a strip substrate in which multiple individual products are arranged with a dummy area between them, a quad substrate with a dummy area between multiple strip substrates, and a panel substrate with a dummy area between multiple quad substrates, and a glass substrate can be applied as a core to manufacture them. The glass substrate (core substrate or core layer) may be cut in a state in which individual semiconductor chips or chip units are mounted or may be mounted during or after an upper layer and/or a lower layer is disposed.

That is, the packaging substrate or glass substrate (core substrate or core layer) may have a pattern of a predetermined size and may be cut in a state in which individual semiconductor chips or chip units are mounted or may be mounted. Such cutting, separation, and division processes of the substrate may be referred to as dicing or singulation. Hereinafter, the packaging substrate refers to both a packaging substrate before singulation in which individual packaging substrates are disposed or a substrate in a singlet state according to the context.

In the present specification, dicing or singulation may mean dividing a packaging substrate comprising a glass substrate as a core layer into several units. In addition, a substrate on which a glass substrate is used as a core layer may be referred to as a core substrate, a glass substrate, a packaging substrate, etc.

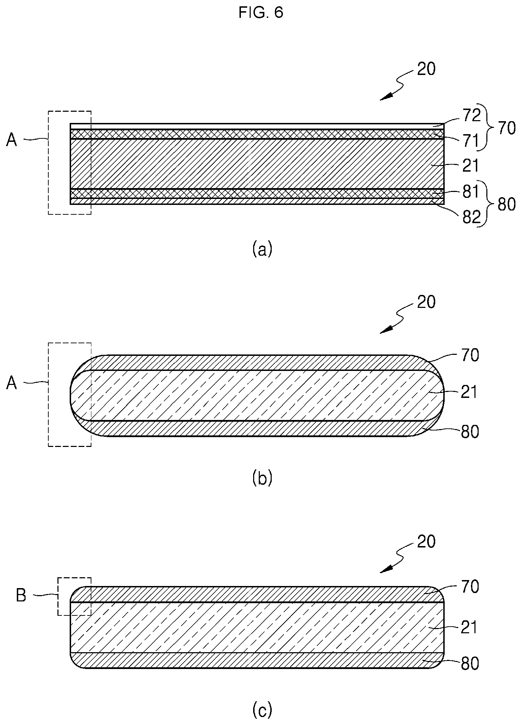

(a) to (c) of FIG. 6 are views for explaining a cross section of a packaging substrate according to an embodiment.

As described with reference to FIGS. 1 to 5, a core via and a cavity portion may be formed on the glass substrate 21, a core distribution layer and a cover layer may be formed on the upper layer, and the lower layer may also have a multilayer structure comprising an insulating layer and a metal distribution pattern. In the following drawings, for convenience of explanation, the packaging substrate 20 comprising the glass substrate 21, the upper layer 70 formed on the first surface of the glass substrate 21, and the lower layer 80 formed on the second surface will be briefly described, and detailed descriptions of the remaining detailed configurations will be omitted.

According to an embodiment illustrated in FIG. 6, an upper layer 70 is disposed on a first surface of a glass substrate 21. Selectively, a lower layer 80 may be disposed on a second surface of the glass substrate 21.

The upper layer 70 may comprise an upper distribution layer 71 having a multilayer stacked structure comprising an upper metal pattern (upper distribution pattern) and an upper insulating layer, and a first cover layer 72 formed on the upper distribution layer 71 to protect the substrate. The specific arrangement of the upper distribution pattern and the upper insulating layer in the upper distribution layer is omitted from the expression of the drawing.

The lower layer 80 may also comprise a lower distribution layer 81 formed in a multilayer structure comprising a lower metal pattern (lower distribution pattern) and a lower insulating layer, and a second cover layer 82 formed on the lower distribution layer 81 to finally planarize and protect the substrate. Arrangement of the lower distribution pattern and the lower insulating layer in the lower distribution layer is omitted from the drawing.

The first cover layer 72 and/or the second cover layer 82 may be implemented as a solder resist for protecting the surface circuit from external environment. Alternatively, according to an embodiment, the first cover layer 72 and/or the second cover layer 82 may be implemented as a polyimide film (PI) which is a heat-resistant insulating film having high thermal stability and high mechanical strength.

A core via, a cavity portion, and a metal pattern layer are formed on the glass substrate 21, and the packaging substrate may be cut into a specific unit. The cutting may be performed after or before a semiconductor element (not shown) is mounted on the upper layer 70.

The packaging substrate may be cut according to a cutting line disposed at a predetermined position.

A metal pattern layer may not be disposed in the upper layer 70 and/or the lower layer 80 inside the cutting line. That is, only an insulating layer or a protective layer may be disposed on a part of the upper layer 70 and/or the lower layer 80 to be cut and removed.

The cut packaging substrate 20 generally has a cross section as shown in (a) of FIG. 6. That is, the cut surface and the first surface or the cut surface and the second surface of the packaging substrate 20 generally form a right angle, and the corners have a sharp shape.

In the structure as shown in (a) of FIG. 6, cracks and breakages derived from the edge or cut surface of the glass substrate 21 may easily occur, so a packaging substrate such as (b) or (c) of FIG. 6 is proposed according to an embodiment of the present disclosure.

According to an embodiment, as shown in (b) of FIG. 6, the cut surface of the glass substrate 21 may have a shape protruding from the upper layer 70 and/or the lower layer 80. That is, the glass substrate 21 may have an edge region 213a that is an edge protruding from the upper layer 70 and/or the lower layer 80. In the edge region of the first surface and/or the edge region 213a of the second surface adjacent to the cut surface of the glass substrate 21, the upper layer 70 and/or the lower layer 80 may be removed so that the first surface and/or the second surface of the glass substrate 21 may be exposed to the outside.

According to an embodiment, as shown in (b) of FIG. 6, the cut surface of the glass substrate 21 may have a shape protruding from the upper distribution layer 71 and/or the lower distribution layer 81. That is, the glass substrate 21 may have an edge region 213a, which is an edge protruding from the upper distribution layer 71 and/or the lower distribution layer 81. In the edge region of the first surface and/or the edge area 213a of the second surface adjacent to the cut surface of the glass substrate 21, the upper distribution layer 71 and/or the lower distribution layer 81 may be removed so that the first surface and/or the second surface of the glass substrate 21 may be exposed to the outside.

In the edge region of the first surface and/or the edge region 213a of the second surface adjacent to the cut surface of the glass substrate 21, the upper distribution layer 71 and/or the lower distribution layer 81 may be removed so that the first surface and/or the second surface of the glass substrate 21 may be exposed to the outside. In the upper distribution layer 71 and/or the lower distribution layer 81, two or more layers, three or more layers, four or more layers, or five or more layers may be disposed on the upper layer 70 and the lower layer 80, respectively. In addition, 10 or less layers, 8 or less layers, or 6 or less layers may be disposed.

According to an embodiment, the upper layer 70 may further comprise an insulating layer such as the first cover layer 72 stacked on the first surface, the edge of the insulating layer is disposed inward from the edge of the glass substrate 21, and the edge region 213a may comprise a region from the edge of the glass substrate 21 to the edge of the insulating layer.

In addition, the lower layer 80 may further comprise an insulating layer such as the second cover layer 82 stacked on the second surface, the edge of the insulating layer is placed inward from the edge of the glass substrate 21, and the edge region 213a may comprise an area from the edge of the glass substrate 21 to the edge of the insulating layer.

The cutting process may be a process in which the panel substrate is cut into a quad substrate.

The cutting process may be a process in which the quad substrate is cut into a strip substrate.

The cutting process may be a process in which a strip substrate is cut into an individual packaging substrate.

This is collectively referred to as a process of cutting in units.

In a cutting process of the packaging substrate 20, that is, a process of cutting in units, the upper layer 70 or the lower layer 80 may be removed, and through this process, the side surface of the glass substrate 21 may protrude in the cutting direction than the layer stacked above or below. The removal may be applied by a method such as laser irradiation but is not limited thereto.

The width of the edge region 213a in which the upper layer 70 or the lower layer 80 is removed to expose the glass substrate 21, that is, the width from the edge of the insulating layer to the edge of the glass substrate 21 may be, for example, 5 µm or more, 7 µm or more, 10 µm or more, or 15 µm or more. Also, the width may be 200 µm or less, 150 µm or less, 100 µm or less, or 80 µm or less. That is, a width of the removed portion (removal line) may be at least twice, or 2.2 times or more, of the width described above. Also, a width of the removed portion (removal line) may be at least four times or less, or at least three times.

As shown in (b) of FIG. 6, the glass substrate 21 protrudes in the direction of the cut surface, so that the cross-section of the packaging substrate is reduced in thickness from the upper layer 70 or the lower layer 80 toward the glass substrate 21, so that the overall tapered shape can have a lying "U" shape.

The edge region 213a of the protruding glass substrate 21 may have rounded corners as shown in (c) of FIG. 6. That is, the edge region 213a disposed at the corner of the glass substrate 21 may have a curved surface.

Alternatively, according to an example, the edge region 213a disposed at the edge of the glass substrate 21 may be chamfered.

According to an example, the upper layer 70 or the lower layer 80 may also be removed or ground to have a tapered shape thinning in the direction of the cut surface.

As shown in FIG. 6, when the upper layer is removed from the edge region 213a of the glass substrate 21, the glass substrate 21 is exposed as much as the removed upper layer.

For example, the width from the edge of the insulating layer to the edge of the glass substrate 21 may be, for example, 5 µm or more, 7 µm or more, 10 µm or more, or 15 µm or more. Also, the width of the edge region 213a may be 200 µm or less, 150 µm or less, 100 µm or less, or 80 µm or less.

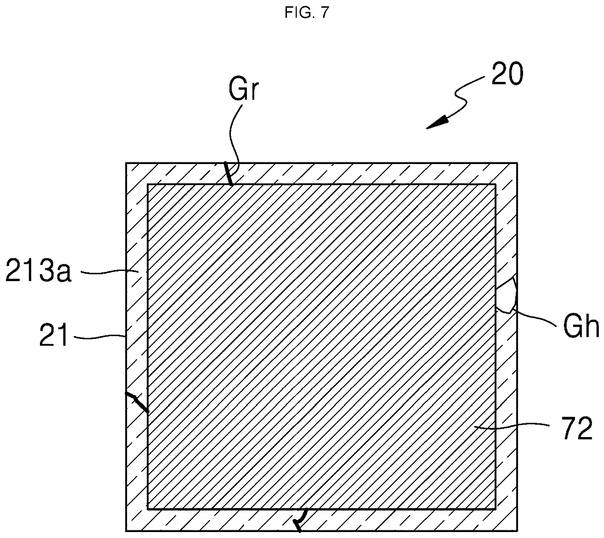

FIG. 7 is a view illustrating a packaging substrate according to an embodiment viewed from above.

As shown, when looking at the packaging substrate from the top, the first cover layer 72 is formed on the first surface of the glass substrate 21, and the upper layer comprising the first cover layer 72 is removed from the edge region 213a. When the glass substrate 21 has a rectangular shape, the upper layer may be removed along four sides of the glass substrate 21. In other words, the edge of the first cover layer 72 is disposed inward from the edge of the glass substrate 21, and the edge region 213a may mean a region from the edge of the glass substrate 21 to the edge of the first cover layer 72.

For example, a glass crack or chipping may be observed in the edge region 213a of the exposed glass substrate 21.

As mentioned above, when a glass substrate is used as a core structure of a packaging substrate, there is a high possibility that the substrate may be broken or cracked due to internal stress and external impact during the manufacturing process. To detect this, analysis of all cross sections of the cut packaging substrate is required. For cross-sectional analysis, inspection using a microscope, or the like is required on the cut surface of the packaging substrate, but in this case, considerable time and cost are required.

According to the present embodiment, as shown in FIG. 7, defects such as cracks or chipping may be quickly and accurately detected only by inspecting the area 213a in which the glass substrate 21 is exposed. In other words, by detecting defects in the edge region 213a and the cut surface of the glass substrate 21 from which the upper or lower layers have been removed, it has the advantage of simultaneously performing surface and cross-sectional inspection of the glass substrate without expensive equipment.

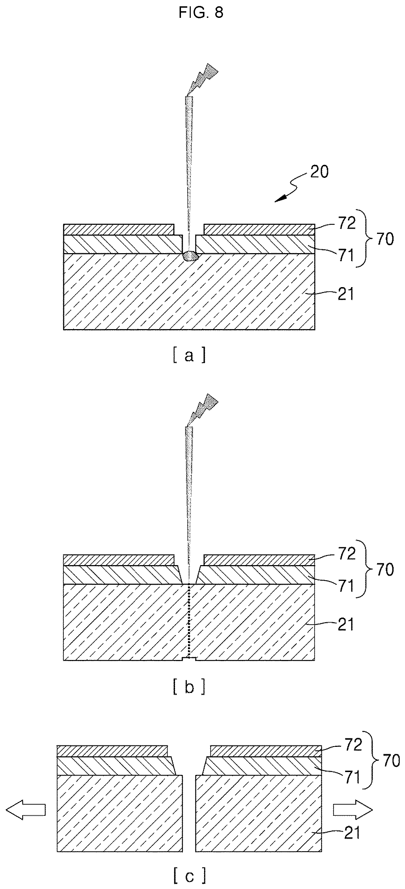

FIG. 8 is a flowchart illustrating a manufacturing method of a packaging substrate according to an embodiment in cross section.

According to an embodiment of FIG. 8, an upper layer 70 may be formed on the first surface of the glass substrate 21, and a semiconductor element (not shown) may be stacked on the upper layer 70.

First, as shown in (a) of FIG. 8, the upper layer 70 may be removed by a predetermined width along a predetermined cutting line using a laser irradiation (Laser Ablation).

The upper layer 70, specifically, an insulating layer such as ABF, may be removed by using a green laser or an ultraviolet laser along a cutting line such as Dicing Street.

In this case, the width of the upper layer 70 to be removed may be about 10 µm to about 400 µm. The width may be 10 µm or more, 14 µm or more, 20 µm or more, 30 µm or more, 40 µm or more, 50 µm or more, 60 µm or more, or 70 µm or more. The width may be 600 µm or less, 550 µm or less, 500 µm or less, 450 µm or less, 400 µm or less, 380 µm or less, 360 µm or less, 340 µm or less, 320 µm or less, 300 µm or less, 280 µm or less, 260 µm or less, 240 µm or less, 220 µm or less, 200 µm or less, or 180 µm or less. The width of the removed upper layer 70 may be set to approximately twice the width of the edge region of the glass substrate 21 to be protruded.

On the other hand, as shown, when the upper layer 70 is removed using a laser, a defect is not substantially formed on the glass substrate 21.

Then, as shown in (b), a filamentation operation may be performed to form a filament along the cutting line on the glass substrate 21 from which the upper layer has been removed (Laser Filamentation).

The method of cutting the substrate using a laser beam such as an infrared laser (IR laser) focuses on the inside of the glass substrate 21 and irradiates it along the desired cutting path, inducing an internal filamentation phenomenon, etc., so that a cutting groove with a certain depth is formed inside the glass substrate 21. By forming a filament, a defect may be formed in the inside of the glass substrate 21 along the cut surface.

As the ultrashort wave laser beam passes through the glass substrate 21, some of it is absorbed and transmits energy to the constituent molecules. Due to the characteristics of the ultrashort wave laser pulse having high-energy, the absorbed energy density is also high, and plasma is instantaneously formed inside the glass substrate 21. When a continuous pulse comes in, such plasma may affect the optical properties of the subsequent pulse. The plasma generated in this way disappears after a certain lifetime, which transforms it into a structure different from the surrounding materials, but depending on the cutting conditions, a narrow and long empty space is formed in the irradiated part of the ultrashort wave laser beam in the thickness direction, which is called "filament (filamentation)."

Filament is distinguished from a gap or crack caused by thermal expansion. Since the pulse width is shorter than the reaction time of the molecular bonding structure, rather than heat or vibration energy affecting the surrounding molecules, energy is concentrated on a portion to which the ultrashort wave laser beam is irradiated, thereby forming an instantaneously elongated gap.

When the filamentation is formed, as shown in (c) of FIG. 8, the glass substrate 21 can be cut using the filamentation, that is, the glass substrate 21 can be separated into units (Separation).

As illustrated, the glass substrate 21 may be separated by applying tensile stress or rotational torque to the filamentation in order to cut the glass substrate 21.

Alternatively, the glass substrate 21 may be separated using a laser or a dicing saw according to another embodiment.

As shown in (c) of FIG. 8, when the glass substrate 21 is separated into a predetermined unit, the insulating layers of the upper layer 70 are tapered in the direction of the cut surface of the glass substrate 21, and the glass substrate 21 has a shape in which the upper layer 70 is exposed and protrudes in the direction of the cut surface.

According to an embodiment, when a green laser is used to remove the upper layer 70, the irradiated laser speed of the upper layer 70 may be 20 mm/s to 40 mm/s, and the laser speed used for filamentation irradiation may be 50 mm/s to 150 mm/s, for example, 80 mm/s to 120 mm/s.

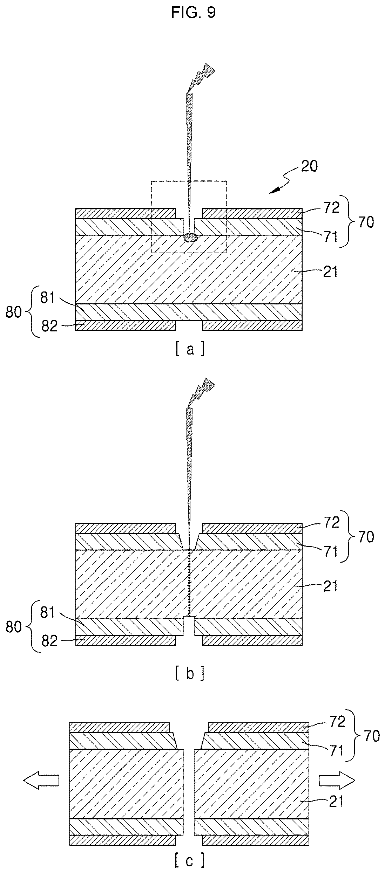

FIG. 9 is a flowchart illustrating a manufacturing method of a packaging substrate according to another embodiment in a cross section.

As shown in (a) of FIG. 9, an upper layer 70 is formed on the first surface of the glass substrate 21, and a lower layer 80 is formed on the second surface. In other words, only the upper layer 70 was removed from the glass substrate 21 of FIG. 8 because the upper layer 70 was formed only on the first surface of the first and second surfaces, but in FIG. 9, since the lower layer 80 comprising the insulating layer is formed on the second surface of the glass substrate 21, the insulating layer may be removed from both sides.

The width of the upper layer 70 to be removed and the width of the lower layer 80 to be removed may have the same range. Specifically, the removed width of the lower layer 80 may be 5 µm or more, 7 µm or more, 10 µm or more, or 15 µm or more based on the width from the edge of the insulating layer to the edge of the glass substrate. In addition, the width above may be 200 µm or less, 150 µm or less, 100 µm or less, or 80 µm or less.

The width of the upper layer 70 and the width of the lower layer 80 to be removed may vary depending on the design of the mounted semiconductor element or the mother board. The removal width of the lower layer 80 may be greater than that of the upper layer 70, and specifically, the difference between the removal width of the upper layer and the removal width of the lower layer may be 1 µm or more, 3 µm or more, 5 µm or more, or 10 µm or more. The difference may be 20 µm or less.

The laser irradiation intensity for removing the insulating layer is not greater than the irradiation intensity for forming the filamentation, and even if lasers are used on both surfaces, damage or defects may not be formed on the glass substrate 21.

The insulating layer may be removed by simultaneously or sequentially irradiating lasers to both surfaces in which the upper layer 70 and the lower layer 80 are formed. On the other hand, the laser for removing the upper layer 70 and the lower layer 80 can be applied on both sides, but as shown in (b) of FIG. 9, the laser for generating filaments can only be irradiated on one single side of the first surface or the second surface.

The separation of the glass substrate 21 after the filamentation operation may be performed based on tension or rotation torque caused by an external force as shown in (c) of FIG. 9.

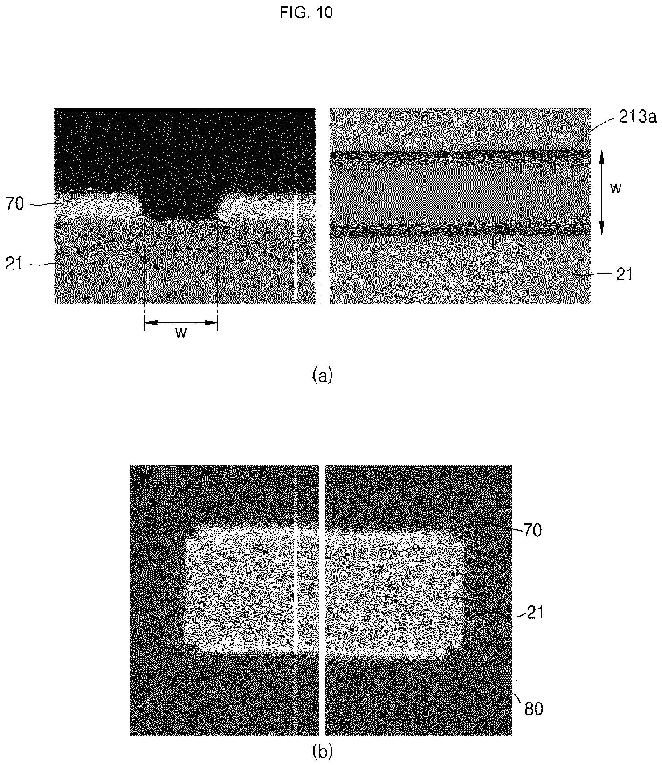

(a) and (b) of FIG. 10 are photographs obtained by photographing samples at a process of manufacturing a packaging substrate according to an embodiment.

(a) of FIG. 10 is a cross-sectional view and top view photograph of a glass substrate 21 (before the upper layer 70 is separated into units) from which the upper layer 70 has been removed, as shown in (a) of FIG. 8 or (a) of FIG. 9. That is, it is a photograph corresponding to the enlarged dotted square area of (a) of FIG. 9, which is a part of the substrate.

As shown in the sectional view of (a) of FIG. 10, the upper layer 70 was removed by a predetermined width w, and the glass substrate 21 was exposed by the width w removed from the upper plane (Top View). In addition, as can be observed from the sectional view, even if the upper layer 70 is removed, no defect is formed on the glass substrate 21. In addition, the removed upper layer 70 may have a tapered shape that becomes thin in the direction of the cut surface to be cut.

(b) of FIG. 10 is a photograph showing the edge cut after the glass substrate 21 is cut into units according to (a) of FIG. 8 and (a) of FIG. 9. The glass substrate 21 is generally separated similar to a straight line, and the upper layer 70 and the lower layer 80 are placed inward from the edge of the glass substrate by a certain distance on both sides of the glass substrate.

As illustrated, the glass substrate 21 may have a filamentation formed along a predetermined cutting line and may be separated based on it. This separation reduces the likelihood of defects issued or inherent in glass, and even if a defect occurs, it can be confirmed in a fast and relatively simple way, thereby improving the efficiency of the semiconductor packaging substrate manufacturing operations, comprising a unitization operation of the glass substrate.

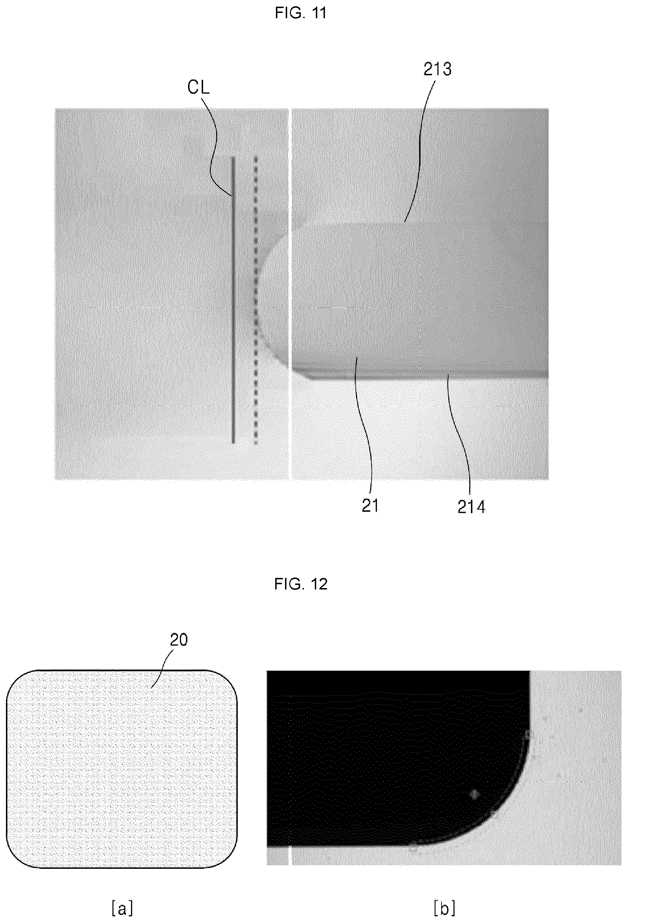

Meanwhile, according to an embodiment, the edge region disposed at the edge of the glass substrate 21 may be processed to be curved. That is, the edge region of the glass substrate 21 may be ground. That is, the edge of the glass substrate 21 may be smoothly trimmed in the cut sharp state (see an example photo of FIG. 11).

FIG. 11 is a photograph of a cross section of a ground glass substrate according to an embodiment.

As illustrated, a cut surface of the glass substrate 21 protruding from the upper layer or the lower layer (indicated by "Cutting Line" in FIG. 11) may be rounded when viewed from a cross section through grinding.

The edge of the glass substrate removed through the grinding process may be approximately 10 µm or more, 20 µm or more, 30 µm or more, or 50 µm or more, and may be approximately 100 µm or less.

Through grinding, the edge of the cut surface may have a curved shape as shown in FIG. 11 and may be deformed into a C-shape or an R-shape chamfer according to another embodiment.

In the packaging substrate 20 having a cut surface, when viewed from the side (or cross section), a side surface corresponding to the thickness may be ground. For example, the shape of the ground side surface where the side surface and the top surface of the packaging substrate meet may be a flat edge, and a penil edge where the side surface connecting the top surface and the bottom surface is rounded so that the center of the side surface protrudes.

The side surface (edge) of the packaging substrate 20 may have a straight line or a part of the glass broken immediately after the formation of the cut surface and may be manufactured in a form having a constant radius of curvature by grinding it. In this case, the radius of curvature is referred to as a radius of side surface curvature.

The radius of side surface curvature of the packaging substrate 20 may be 0.05 mm or more, 0.1 mm or more, 0.15 mm or more, or 0.2 mm or more. The radius of side surface curvature may be 2.0 mm or less, 1.8 mm or less, 1.6 mm or less, 1.2 mm or less, 1 mm or less, 0.8 mm or less, or 0.6 mm or less. In this case, workability can be improved, such as minimizing the occurrence of breakage of the packaging substrate or glass substrate in the process of manufacturing and transporting.

For example, when grinding is performed by setting the design angle of the blade to 90°±1° and the cutting amount to 0.08 to 0.14 mm, a packaging substrate having an edge curvature radius of 0.241 mm may be manufactured.

In addition, for example, when grinding is performed by setting the design angle of the blade to 120°±1° and the cutting amount to 0.05 to 0.12 mm, a packaging substrate with an edge curvature radius of 0.522 mm can be manufactured.

FIG. 12 is a photograph of a glass substrate viewed from above and a portion thereof according to another embodiment. In the glass substrate, not only the cross section, but also the part corresponding to the corner of the square when viewed from above may be rounded. (a) of FIG. 12 shows the unit glass substrate viewed from above, and as shown, the first surface 213 and the second surface 214 can also be rounded with rounded corners.

The rectangular packaging substrate has four corners when viewed from above, and each corner is rounded to have a predetermined curvature to remove the angled part. This radius of curvature is referred to as a radius of substrate curvature. The radius of substrate curvature may be 0.5 mm or more, 1 mm or more, 1.2 mm or more, or 1.5 mm or more. The radius of substrate curvature may be 8 mm or less, 7 mm or less, 6 mm or less, or 5 mm or less. In this case, it is possible to minimize the occurrence of breakage of corners and stably ensure a region in which an electric conductive layer of an upper layer and/or a lower layer is disposed.

Meanwhile, according to an embodiment, the vertex of the square-shaped glass substrate 21 may also be curved through grating. When the vertex portion is ground, the risk of damage or breakage may be reduced when moving the glass substrate 21 or transporting it to a tray or the like. The curvature of the ground vertex portion may be derived as an appropriate value by setting a diameter in which the deviation from the predetermined target value occurs smallest.

The cut surface of the glass substrate, which is cut and not processed, has a nonuniform right angle deviation. Accordingly, hackles may occur even in the cut corner portion, and thus there may be a risk of additional damage such as cracks or chipping of the glass substrate. Through grinding, a glass substrate having a curved edge or a chamfer-shaped cut surface may significantly reduce the risk of such additional damage. In addition, external shocks can be properly dispersed when transporting trays for the movement or additional process of glass or packaging substrates, and defects due to cracks or chipping can be minimized.

According to another embodiment, the grinding may be applied not only to the protruding glass substrate 21 but also to the upper layer or the lower layer.

The packaging substrate and the manufacturing method thereof according to the embodiments described above are effective in inspecting defects that may occur in the packaging substrate comprising the glass structure and effectively protect the glass substrate from external impact.

Defects occurring in the glass substrate used in the packaging substrate of the embodiment can be easily detected.

In addition, the embodiment provides a packaging substrate capable of simultaneously detecting defects occurring on the surface and cross section of a glass substrate and a manufacturing method thereof.

In addition, embodiments can effectively detect splits and breakages that may occur on glass substrates at low costs.

## Claims

1. A manufacturing method of a packaging substrate (20), comprising;
a forming operation of an upper layer (70) on a first surface (213) of a glass substrate (21) comprising the first surface (213) and a second surface (214) facing each other;
a removing operation of the upper layer (70) by a predetermined width along a predetermined cutting line;
a forming operation of a filamentation along the cutting line on the glass substrate (21) from which the upper layer (70) has been removed; a cutting operation of the glass substrate (21) using the filamentation; and
a detecting operation,
wherein an edge area (213a) comprises the edge of the glass substrate (21); and the area of the glass substrate (21) protruding from the upper layer (70) or the lower layer (80),
wherein the detecting operation of detecting defects in any one consisting of the edge area (213a) of the glass substrate (21), the cut surface of the glass substrate (21), the removal line of the upper layer (70), the removal line of the lower layer (80), and combination thereof.

2. The manufacturing method of the packaging substrate (20) of Claim 1, further comprising, before the forming operation of a filamentation,
a forming operation of a lower layer (80) on the second surface (214); and
a removing operation of the lower layer (80) by a predetermined width along the cutting line.

3. The manufacturing method of the packaging substrate (20) of Claim 1 or Claim 2, wherein the predetermined width is 5 µm or more.

4. The manufacturing method of the packaging substrate (20) of any one from Claim 1 to Claim 3, wherein the upper layer (70) or the lower layer (80) each has a tapered shape that becomes thinner in the direction of a cut surface of the glass substrate (21).

5. The manufacturing method of the packaging substrate (20) of any one from Claim 1 to Claim 4,
wherein the cutting operation of the glass substrate (21) is separating the glass substrate (21) by applying tensile stress or rotational force to the filament.

6. The manufacturing method of the packaging substrate of any one from Claim 1 to Claim 5, further comprising a grinding operation of a cut surface, after the cutting operation of the glass substrate (21).

7. The manufacturing method of the packaging substrate of any one from Claim 1 to Claim 6, further comprising a forming operation of forming a core via (23) in a glass substrate (21) passing through the first surface (213) and the second surface (214).

## Patentansprüche

1. Herstellungsverfahren eines Verpackungssubstrats (20), umfassend:
einen Ausbildungsvorgang einer oberen Schicht (70) auf einer ersten Oberfläche (213) eines Glassubstrats (21), das die erste Oberfläche (213) und eine zweite Oberfläche (214), die einander zugewandt sind, umfasst;
einen Entfernungsvorgang der oberen Schicht (70) um eine vorbestimmte Breite entlang einer vorbestimmten Schnittlinie;
einen Ausbildungsvorgang einer Filamentierung entlang der Schnittlinie auf dem Glassubstrat (21), von dem die obere Schicht (70) entfernt wurde; einen Schneidevorgang des Glassubstrats (21) unter Verwendung der Filamentierung; und
einen Detektierungsvorgang,
wobei ein Randbereich (213a) den Rand des Glassubstrats (21) umfasst; und der Bereich des Glassubstrats (21) von der oberen Schicht (70) oder der unteren Schicht (80) vorsteht,
wobei der Detektierungsvorgang ein Detektieren von Defekten in einem beliebigen, bestehend aus dem Randbereich (213a) des Glassubstrats (21), der geschnittenen Oberfläche des Glassubstrats (21), der Entfernungslinie der oberen Schicht (70), der Entfernungslinie der unteren Schicht (80) und einer Kombination davon, umfasst.

2. Herstellungsverfahren des Verpackungssubstrats (20) nach Anspruch 1, ferner umfassend, vor dem Ausbildungsvorgang einer Filamentierung,
einen Ausbildungsvorgang einer unteren Schicht (80) auf der zweiten Oberfläche (214); und
einen Entfernungsvorgang der unteren Schicht (80) um eine vorbestimmte Breite entlang der Schnittlinie.

3. Herstellungsverfahren des Verpackungssubstrats (20) nach Anspruch 1 oder Anspruch 2, wobei die vorbestimmte Breite 5 µm oder mehr beträgt.

4. Herstellungsverfahren des Verpackungssubstrats (20) nach einem von Anspruch 1 bis Anspruch 3, wobei die obere Schicht (70) oder die untere Schicht (80) jeweils eine verjüngte Form aufweist, die in der Richtung einer geschnittenen Oberfläche des Glassubstrats (21) dünner wird.

5. Herstellungsverfahren des Verpackungssubstrats (20) nach einem von Anspruch 1 bis Anspruch 4,
wobei der Schneidevorgang des Glassubstrats (21) das Trennen des Glassubstrats (21) durch Anwenden von Zugspannung oder Drehkraft auf das Filament ist.

6. Herstellungsverfahren des Verpackungssubstrats nach einem von Anspruch 1 bis Anspruch 5, ferner umfassend einen Schleifvorgang einer geschnittenen Oberfläche nach dem Schneidevorgang des Glassubstrats (21).

7. Herstellungsverfahren des Verpackungssubstrats nach einem von Anspruch 1 bis Anspruch 6, ferner umfassend einen Ausbildungsvorgang zum Ausbilden eines Kernkontaktlochs (23) in einem Glassubstrat (21), das durch die erste Oberfläche (213) und die zweite Oberfläche (214) verläuft.

## Revendications

1. Procédé de fabrication d'un substrat d'encapsulation (20), comprenant :
une opération de formation d'une couche supérieure (70) sur une première surface (213) d'un substrat en verre (21) comprenant la première surface (213) et une deuxième surface (214) opposées l'une à l'autre ;
une opération de retrait de la couche supérieure (70) d'une largeur prédéterminée le long d'une ligne de coupe prédéterminée ;
une opération de formation d'un défibrage le long de la ligne de coupe sur le substrat en verre (21) dont la couche supérieure (70) a été retirée ;
une opération de coupe du substrat en verre (21) au moyen du défibrage ; et
une opération de détection,
où une zone de bord (213a) comprend le bord du substrat en verre (21) ; et la zone du substrat en verre (21) faisant saillie de la couche supérieure (70) ou de la couche inférieure (80),
où l'opération de détection consiste à détecter des défauts dans n'importe quelle étendue comprenant la zone de bord (213a) du substrat en verre (21), la surface découpée du substrat en verre (21), la ligne de retrait de la couche supérieure (70), la ligne de retrait de la couche inférieure (80), ou une combinaison de celles-ci.

2. Procédé de fabrication d'un substrat d'encapsulation (20) selon la revendication 1, comprenant en outre, avant l'opération de formation d'un défibrage,
une opération de formation d'une couche inférieure (80) sur la deuxième surface (214) ; et une opération de retrait de la couche inférieure (80) d'une largeur prédéterminée le long de la ligne de coupe.

3. Procédé de fabrication d'un substrat d'encapsulation (20) selon la revendication 1 ou la revendication 2, où la largeur prédéterminée est de 5 µm ou plus.

4. Procédé de fabrication d'un substrat d'encapsulation (20) selon l'une des revendications 1 à 3, où la couche supérieure (70) et la couche inférieure (80) ont chacune une forme en biseau s'amincissant dans la direction d'une surface de découpe du substrat en verre (21).

5. Procédé de fabrication d'un substrat d'encapsulation (20) selon l'une des revendications 1 à 4,
où l'opération de coupe du substrat en verre (21) consiste à séparer le substrat en verre (21) par application d'une contrainte de traction ou d'une force de rotation à la fibre.

6. Procédé de fabrication d'un substrat d'encapsulation selon l'une des revendications 1 à 5, comprenant en outre une opération de ponçage d'une surface de découpe, après l'opération de coupe du substrat en verre (21).

7. Procédé de fabrication d'un substrat d'encapsulation selon l'une des revendications 1 à 6, comprenant en outre une opération de formage consistant à former un trou d'interconnexion central (23) dans un substrat en verre (21), traversant la première surface (213) et la deuxième surface (214).
